(19) Europäisches Patentamt
European Patent Office
Office européen des brevets

(11) **EP 3 351 714 A1**

(12) **EUROPEAN PATENT APPLICATION**
published in accordance with Art. 153(4) EPC

(43) Date of publication:
**25.07.2018 Bulletin 2018/30**

(21) Application number: **16846307.3**

(22) Date of filing: **06.09.2016**

(51) Int Cl.:
*E05F 15/46* [(2015.01)]   *B60J 1/00* [(2006.01)]
*B60J 1/17* [(2006.01)]   *E05F 15/689* [(2015.01)]

(86) International application number:
**PCT/JP2016/076091**

(87) International publication number:
**WO 2017/047436 (23.03.2017 Gazette 2017/12)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **16.09.2015 JP 2015182493**

(71) Applicant: **Kabushiki Kaisha Tokai Rika Denki Seisakusho**
**Ohguchi-cho**
**Niwa-gun**
**Aichi 480-0195 (JP)**

(72) Inventor: **KANEMATSU, Keishi**
**Niwa-gun**
**Aichi 480-0195 (JP)**

(74) Representative: **Gill, David Alan**
**WP Thompson**
**138 Fetter Lane**
**London EC4A 1BT (GB)**

(54) **SENSOR STRUCTURE AND POWER WINDOW CONTROL DEVICE USING SAME**

(57) A power window control device 1 has: a first electrode 100, which is disposed in an upper portion of a window glass 30 of a vehicle, and which detects electrostatic capacity; and a second electrode 200, which is disposed on the vehicle inner side in the window glass 30, and which detects electrostatic capacity. The first electrode 100 and the second electrode 200 are formed as a bent board-shaped detection electrode 10, and the detection direction of subject to be detected by the first electrode 100 and the detection direction of a subject to be detected by the second electrode 200 are different from each other.

**FIG.1A**

EP 3 351 714 A1

## Description

### Technical field

The present invention relates to a sensor structure and a power window control device using the sensor structure.

### Background art

A power window control device is known that is able to detect, in a non-contact state, a possibility of the trapping of fingers or the like by a window glass (see Patent Document 1, for example).

This power window control device is a window regulator safety device that controls a window regulator, which raises/lowers the window glass using the rotational force of a motor, and is provided with at least a first electrode arranged on an upper end portion of the window glass and a second electrode arranged on a vehicle body side, electrostatic capacitance measurement means for measuring the electrostatic capacitance between the first electrode and the second electrode, determination means for determining the presence or absence of the possibility of the trapping of fingers or the like on the basis of changes in the electrostatic capacitance measured by the electrostatic capacitance measuring means, and driving means for controlling the rotation of the motor with reference to a determination result of the determination means.

The power window control device of Patent Document 1 is provided with the detection electrodes for the finger trap detection, and is also provided with a control unit that detects the changes in the electrostatic capacitance of these detection electrodes and controls an opening and closing operation of the power window. This enables the detection of the possibility of the trapping of fingers or the like, and also makes it possible to issue a trap warning on the basis of the detection.

### Citation list

#### Patent document

Patent Document 1: JP 10-110574A

### Summary of the invention

#### Technical problem

In the power window control device of Patent Document 1, the detection electrodes for the finger trap detection are arranged on the upper end portion of the window glass and on the vehicle body side, and simply have the finger trap detection function.

An object of the invention is to provide a sensor structure having two functions, namely, finger trap detection and another detection function, and a power window control device using the sensor structure.

### Solution to problem

[1] A sensor structure according to an aspect of the invention includes: a first electrode that detects electrostatic capacitance; and a second electrode that detects electrostatic capacitance. The first electrode and the second electrode are a detection electrode having a bent plate-shape, and a detection direction for a detection target of the first electrode and a detection direction for a detection target of the second electrode are different directions.

[2] The sensor structure described in [1] above may be a sensor structure in which a voltage is applied to two locations of corner portions of the first electrode and two locations of corner portions of the second electrode, and a touch position of the first electrode or the second electrode is detected using a surface-based electrostatic capacitance method.

[3] A power window control device according to another aspect of the invention includes a first electrode that is arranged on an upper portion of a window glass of a vehicle and that detects electrostatic capacitance, and a second electrode arranged on a vehicle interior side of the window glass and that detects electrostatic capacitance. The first electrode and the second electrode are a detection electrode having a bent plate-shape, and a detection direction for a detection target of the first electrode and a detection direction for a detection target of the second electrode are different directions.

[4] The power window control device described in [3] above may be a power window control device in which a voltage is applied to two locations of corner portions of the first electrode and two locations of corner portions of the second electrode, and a touch position of the first electrode or the second electrode is detected using a surface-based electrostatic capacitance method.

[5] The power window control device described in [3] or [4] above may be a power window control device in which the first electrode detects trapping of a finger by the window glass, and an opening and closing control of a power window device is performed by the second electrode detecting a touch operation from a vehicle interior side.

[6] The sensor structure or the power window control device described in any one of [1] to [5] above may be a sensor structure or a power window control device in which the first electrode and the second electrode respectively correspond to a first side surface and a second side surface of a shape obtained by bending a single long plate along a line parallel to a longitudinal direction, and the second side surface has a width larger than the first side surface.

[7] The sensor structure or the power window control device described in [6] above may be a sensor structure or a power window control device in which the first side surface meets the second side surface at a substantially right angle.

Advantageous effects of the invention

According to an aspect of the invention, a sensor structure having two functions, namely, finger trap detection and another detection function, and a power window control device using the sensor structure, can be provided.

Brief description of the drawings

FIG. 1A is a front view illustrating a configuration of a power window control device according to an embodiment of the invention.
FIG. 1B is a cross-sectional view taken along line A-A of FIG. 1A illustrating a part of a window glass.
FIG. 2 is a perspective view illustrating an arrangement, with respect to a window glass, of a detection electrode of a power window control device according to an embodiment of the invention.
FIG. 3 is a developed plan view illustrating a first electrode 100 and a second electrode 200 and illustrating locations at which a voltage (a current) is applied to the detection electrode, a touch point P, and X, Y coordinates.
FIG. 4 is a block diagram illustrating the configuration of a power window control device using a sensor structure according to an embodiment of the invention.
FIG. 5 is a flowchart illustrating an example of operations performed by a power window control device according to an embodiment of the invention.

Description of embodiment

Embodiments of Present Invention

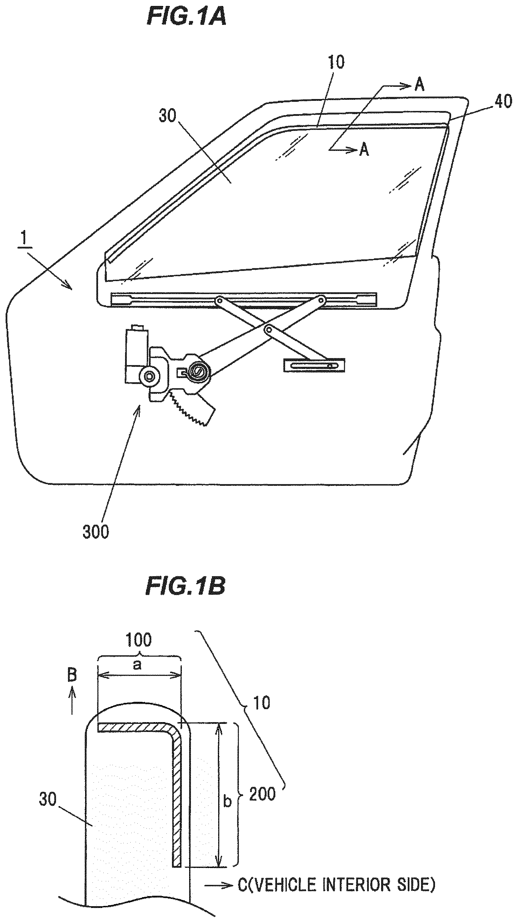

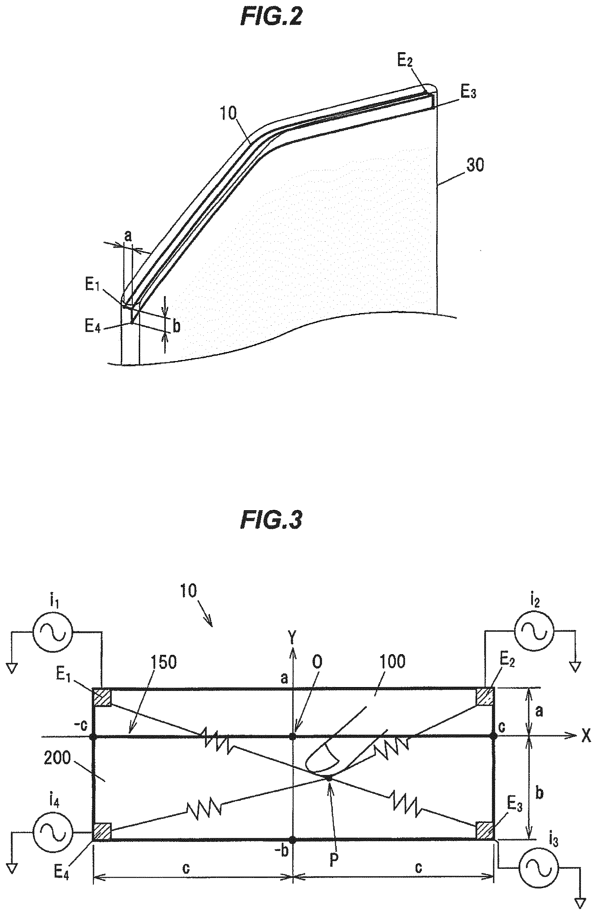

FIG. 1A is a front view illustrating a configuration of a power window control device according to an embodiment of the invention, and FIG. 1B is a cross-sectional view taken along line A-A in FIG. 1A illustrating a part of a window glass. Further, FIG. 2 is a perspective view illustrating an arrangement, with respect to the window glass, of a detection electrode of the power window control device according to the embodiment of the invention.

A sensor structure according to the present embodiment includes a first electrode 100 that detects electrostatic capacitance and a second electrode 200 that detects electrostatic capacitance. The first electrode 100 and the second electrode 200 are formed as a bent plate-shaped detection electrode 10, and are configured such that a detection direction for a detection target of the first electrode 100 and a detection direction for a detection target of the second electrode 200 are different directions.

Further, a power window control device 1 according to the present embodiment includes the first electrode 100 that is arranged on an upper portion of a window glass 30 of a vehicle and that detects the electrostatic capacitance, and the second electrode 200 that is arranged on a vehicle interior side of the window glass 30 and that detects the electrostatic capacitance. The first electrode 100 and the second electrode 200 are formed as the bent plate-shaped detection electrode 10, and are configured such that the detection direction for the detection target of the first electrode 100 and the detection direction for the detection target of the second electrode 200 are different directions.

Detection Electrode 10

The detection electrode 10 is an electrode formed of an electrically conductive material, and an electrostatic capacitance value changes as a result of a finger or the like coming into contact with or coming close to a surface of the detection electrode 10.

The detection electrode 10 is, for example, mounted on the upper portion or the upper end portion of the window glass 30 of the vehicle, as illustrated in FIG. 1A and FIG. 2, and detects the contact or approach of the finger or the like.

The detection electrode 10 includes the first electrode 100 that is arranged on the upper portion of the window glass 30 of the vehicle and that detects the electrostatic capacitance, and the second electrode 200 that is arranged on the vehicle interior side of the window glass 30 and that detects the electrostatic capacitance. The first electrode 100 and the second electrode 200 are formed as the bent plate shape. In addition to an electrically conductive material, such as copper, a transparent electrode, such as indium tin oxide (ITO), can be used as the detection electrode 10.

As illustrated in FIG. 1A, the detection electrode 10 is mounted on the upper portion of the window glass 30 of the vehicle and the window glass 30 can be moved up and down inside a window frame 40 by a window regulator 300. As illustrated in FIG. 1B, the detection electrode 10 mounted on the window glass 30 is configured by the first electrode 100 and the second electrode 200. For the first electrode 100, the detection direction for the finger or the like that is the detection target is the upward direction (the direction of an arrow B) and for the second electrode 200, the detection direction for the finger or the like that is the detection target is the vehicle interior side (the direction of an arrow C). In other words, the detection directions for the detection target of the first electrode 100 and the second electrode 200 are set to be different directions. In this way, for example, the detection electrode 10 enables the trapping of the finger or the like by the window glass 30 and the window frame 40 to be detected using the first electrode 100, while also enabling touch detection or the like from the vehicle interior side (the direction of the arrow C).

As illustrated in FIG. 1B and FIG. 2, the detection electrode 10 is configured by the first electrode 100 having a width a and the second electrode 200 having a width b. As illustrated in FIG. 1B, the first electrode 100 and the second electrode 200 have a shape that is bent so as to have an L-shaped cross-section. Further, the width b of the second electrode 200 is set to be a larger value than that of the width a of the first electrode 100. In this way, a determination in the vicinity of a boundary of the bend can be clearly identified, and further, a touch operation from the vehicle interior side (the direction of the arrow C) can be easily detected.

FIG. 3 is a developed plan view illustrating the first electrode 100 and the second electrode 200 and illustrating locations at which a voltage (a current) is applied to the detection electrode, a touch point P, and X, Y coordinates. As illustrated in FIG. 1A and FIG. 2, the detection electrode 10 has a long shape with respect to the widths a and b, and in FIG. 3, this length direction is designated as 2c and is illustrated in a scaled down manner.

In FIG. 3, an X axis is above a boundary (a bent portion) 150 between the first electrode 100 and the second electrode 200, while a Y axis is at the center in the left to right direction. An intersection point of the X axis and the Y axis is an origin O. An X coordinate of a right end portion of the first electrode 100 and the second electrode 200 is c, and an X coordinate of a left end portion thereof is - c. A Y coordinate of an upper end portion of the first electrode 100 is a, and a Y coordinate of a lower end portion of the second electrode 200 is - b.

Further, in FIG. 3, corner portions E1 and E2 in two locations of the first electrode 100, and corner portions E3 and E4 in two locations of the second electrode 200 are electricity supply units at which a voltage is applied to supply a current.

In the sensor structure according to the present embodiment, the first electrode 100 or the second electrode 200 detects the touch position P using a surface-based electrostatic capacitance method. The touch position detection using the surface-based electrostatic capacitance method is a method in which an AC current is supplied from the electricity supply units in the four locations of the detection electrode 10 (the first electrode 100 and the second electrode 200), and, using impedance changes between the touch position P and the electricity supply units, touch position coordinates are calculated on the basis of ratios of current values of the four locations. By calculating the touch position coordinates, it is possible to determine which of the first electrode 100 or the second electrode 200 has been touched.

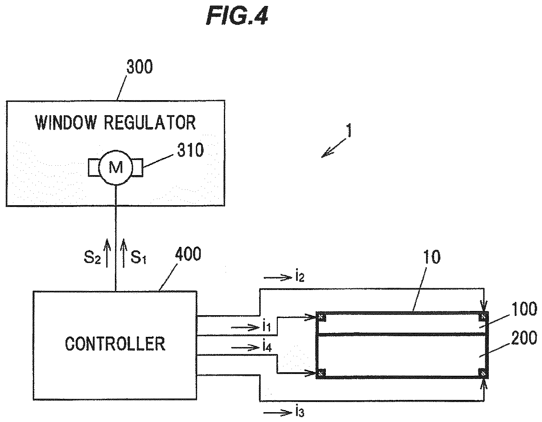

FIG. 4 is a block diagram illustrating a configuration of the power window control device 1 that uses the sensor structure according to the embodiment of the invention.

A controller 400 is configured by the electricity supply units that apply the voltage to the corner portions E1 and E2 in the two locations of the first electrode 100, and to the corner portions E3 and E4 in the two locations of the second electrode 200, and respectively supply currents i1, i2, i3, and i4; a coordinate calculation unit that calculates the touch position coordinates on the detection electrode 10 on the basis of the currents i1, i2, i3, and i4; a control signal generation unit that generates control signals S1 and S2 that perform rotational control of a regulator motor 310 of the window regulator 300; and an arithmetic processing unit that controls the above controls in accordance with a predetermined program.

The controller 400 is, for example, a microcomputer including a central processing unit (CPU) that executes the arithmetic processing in accordance with the program, and a semiconductor memory, such as a RAM, a read only memory (ROM), and the like. Further, the detection electrode 10 is provided with a driver unit for supplying a current to the regulator motor 310, an interface unit that performs the input and output of signals, and the like.

Calculation of Touch Position P

In the detection of the touch position P using the surface-based electrostatic capacitance method, the coordinates of the touch position P are calculated on the basis of ratios between the current values (i1, i2, i3, and i4) flowing through the four locations, namely, the corner portions E1 and E2 in the two locations of the first electrode 100 and the corner portions E3 and E4 in the two locations of the second electrode 200.

In FIG. 3, X, Y coordinates of the touch position P are calculated using the following type of equation.

$$X = K1 + K2 * (i2 + i3)/(i1 + i2 + i3 + i4)$$

$$Y = K3 + K4 * (i1 + i2)/(i1 + i2 + i3 + i4)$$

Note that K1 and K3 are offset values and K2 and K4 are coefficients.

Here, when K1 = 0, K2 = c, K3 = a, and K4 = - a - b, as illustrated in FIG. 3, with respect to a region of the first electrode 100 of the detection electrode 10, the coordinates of the upper end portion are (0, a), the coordinates of the lower end portion are (0, - b), the coordinates of the right end portion are (c, 0), and the coordinates of the left end portion are (-c, 0).

Specifically,

$$X = c * (i2 + i3)/(i1 + i2 + i3 + i4)$$

and

$$Y = a - (a + b) * (i1 + i2)/(i1 + i2 + i3 + i4).$$

Thus, on the basis of the current values (i1, i2, i3, and i4) supplied from the corner portions E1 and E2 in the two locations of the first electrode 100 and the corner portions E3 and E4 in the two locations of the second electrode 200, the X, Y coordinates of the touch position P can be calculated in the controller 400 using the above-described equations.

Using the above-described equations, the sensor structure according to an embodiment of the invention can calculate the X, Y coordinates of the touch position P, and in this way, can determine whether the first electrode 100 has been touched or the touch operation has been performed on the second electrode 200. Further, which position with respect to the first electrode 100 and the second electrode 200 has been touched can also be determined, and thus, the sensor structure can perform not only the touch detection, but can also function as a switch input device on the basis of the touch position.

Operations of Power Window Control Device

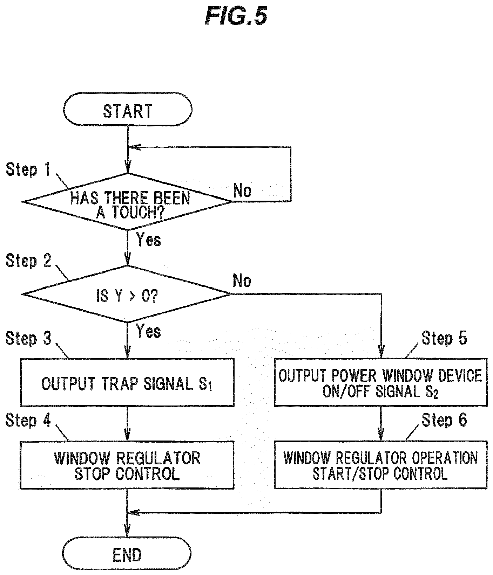

FIG. 5 is a flowchart illustrating an example of operations performed by the power window control device 1 according to an embodiment of the invention.

The controller 400 determines whether or not the detection electrode 10 (the first electrode 100 and the second electrode 200) has been touched (Step 1). Since the electrostatic capacitance value changes at the touch position P, the controller 400 can determine the presence or absence of the touch on the basis of whether or not the electrostatic capacitance value has exceeded a predetermined threshold value. When the touch is detected, the operation advances to Step 2, and when the touch is not detected, Step 1 is repeatedly performed.

The controller 400 determines whether or not, with respect to the Y coordinate of the touch position P, Y > 0 (Step 2). The controller 400 calculates the Y coordinate using the equations:

$$X = c * (i2 + i3)/(i1 + i2 + i3 + i4) \text{ and}$$

$$Y = a - (a + b) * (i1 + i2)/(i1 + i2 + i3 + i4),$$

and performs the determination on the basis of this. When Y > 0 applies, the operation advances to Step 3, and when Y > 0 does not apply, the operation advances to Step 5.

When the Y coordinate of the touch position P is Y > 0, the controller 400 generates a trap signal S1 and outputs the trap signal S1 to the window regulator 300 (Step 3).

The window regulator 300 can perform rotation control of the regulator motor 310 on the basis of the trap signal S1, using a regulator controller that is not illustrated (Step 4). Specifically, on the basis of the trap signal S1, it is determined that the first electrode 100 has detected trapping of the finger by the window glass 30, and the regulator motor 310 is controlled to rotate in the reverse direction. In this way, even if the window glass 30 is being moved in the upward direction by the window regulator 300, this is reversed and the window glass 30 is caused to move in the downward direction, thus enabling the trapping of the finger or the like to be avoided. Alternatively, the regulator motor 310 need not be controlled to rotate in the reverse direction, and control may be performed so as to stop the rotation thereof.

When the Y coordinate of the touch position P is not Y > 0, the controller 400 generates an on/off signal S2 and outputs the on/off signal S2 to the window regulator 300 (Step 5).

The window regulator 300 can perform operation start and stop control of the regulator motor 310 on the basis of the on/off signal S2, using the regulator controller that is not illustrated (Step 6). Specifically, on the basis of the on/off signal S2, when the regulator motor 310 is stopped, the operation thereof can be started, and when the regulator motor 310 is operating, control can be performed to stop the operation thereof. In this way, an operator can start and stop the operation of the power window by performing the touch operation on the second electrode 200 from the interior of the vehicle.

Through the flow of the above-described series of operations, the control of the window regulator 300 ends. Note that the flow of this series of operations can be set to be repeated as necessary.

Switch Input Function of Second Electrode 200

As described above, the first electrode 100 detects the trapping of the finger by the window glass 30. Meanwhile, in addition to the power window operation start and stop switch input described above, various input functions can be assigned to the second electrode 200. As well as detecting the presence or absence of the touch, the detection electrode 10 (the first electrode 100 and the second electrode 200) can calculate the coordinates of the touch position P. Thus, in particular, various functions can be allocated to the second electrode 200, by determining the coordinates of a position that has been touched by the operator from the interior of the vehicle.

For example, the functions can be allocated in accordance with whether the touch position of the second electrode 200 is at the front, the center or the rear of the window glass 30. For example, the operation of the power window is started when the second electrode 200 of the window glass 30 has been touched toward the front, the operation of the power window is stopped when the touch is toward the center, and the power window is caused to rotate in reverse when the touch is toward the rear, and the like.

Effects of Embodiments of Invention

The sensor structure and the power window control device 1 according to the present embodiment have the following effects.

(1) In the sensor structure according to the present embodiment, the first electrode 100 or the second electrode 200 detects the touch position P using the surface-based electrostatic capacitance method. The touch position detection using the surface-based electrostatic capacitance method is a method in which the AC current is supplied from the electricity supply units at the four locations of the detection electrode 10 (the first electrode 100 and the second electrode 200), and the touch position coordinates are calculated on the basis of the ratios of the current values of the four locations, using impedance changes between the touch position P and the electricity supply units. As a result, as well as being able to detect the presence or absence of the touch, by calculating the touch position coordinates, it is possible to determine which of the first electrode 100 or the second electrode 200 has been touched.

(2) In the power window control device 1 that uses the above-described sensor structure, as well as being able to perform the reverse operation control and the stop control of the window regulator 300 using the touch detection of the first electrode 100, by detecting the touch operation by the operator on the second electrode 200 from the interior of the vehicle, the start and stop operation of the power window can also be performed.

(3) In this way, the sensor structure having the two functions of the finger trap detection and the other function, and the power window control device 1 that uses this sensor structure, can be provided.

(4) Using the above-described equations, the sensor structure according to an embodiment of the invention can calculate the X, Y coordinates of the touch position P, and thus can go so far as to determine on which position, on the first electrode 100 or the second electrode 200, the touch operation has been performed. Thus, the sensor structure can also function as the switch input device on the basis of the touch position.

Although several embodiments of the invention have been described above, these embodiments are merely examples and the invention according to the claims is not to be limited thereto. These novel embodiments may be implemented in various other forms, and various omissions, substitutions, changes, and the like can be made without departing from the spirit and scope of the invention. In addition, all the combinations of the features described in these embodiments are not necessarily needed to solve the technical problem. Further, these embodiments are included within the spirit and scope of the invention and also within the invention described in the claims and the scope of equivalents thereof. Reference signs list

1 Power window control device
10 Detection electrode
30 Window glass
40 Window frame
100 First electrode
200 Second electrode

**Claims**

1. A sensor structure, comprising:

a first electrode configured to detect electrostatic capacitance; and
a second electrode configured to detect electrostatic capacitance,
wherein the first electrode and the second electrode are arranged to provide a detection electrode having a bent plate-shape, and
wherein a detection direction for a detection target of the first electrode and a detection direction for a detection target of the second electrode are different directions.

2. The sensor structure according to claim 1, wherein a voltage is applied to corner portions in two locations of the first electrode and corner portions in two locations of the second electrode, and
wherein a touch position of one of the first electrode and the second electrode is detected by surface capacitive type sensing.

3. A power window control device, comprising:

a first electrode arranged on an upper portion of a window glass of a vehicle and configured to detect electrostatic capacitance; and
a second electrode arranged on a vehicle interior side of the window glass and configured to detect electrostatic capacitance,
wherein the first electrode and the second electrode are arranged to provide a detection electrode having a bent plate-shape, and
wherein a detection direction for a detection target of the first electrode and a detection direction for a detection target of the second electrode are different directions.

4. The power window control device according to claim 3, wherein a voltage is applied to corner portions in two locations of the first electrode and corner portions in two locations of the second electrode, and wherein a touch position of one of the first electrode and the second electrode is detected by surface capacitive type sensing.

5. The power window control device according to claim 3 or 4, wherein the first electrode detects trapping of a finger by the window glass, and an opening and closing control of a power window device is performed by the second electrode detecting a touch operation from an interior side of the vehicle.

6. The sensor structure according to claim 1 or 2, wherein the first electrode and the second electrode respectively correspond to a first side surface and a second side surface of a shape obtained by bending a single long plate along a line parallel to a longitudinal direction, and wherein the second side surface has a width larger than the first side surface.

7. The power window control device according to any one of claims 3 to 5, wherein the first electrode and the second electrode respectively correspond to a first side surface and a second side surface of a shape obtained by bending a single long plate along a line parallel to a longitudinal direction, and wherein the second side surface has a width larger than the first side surface.

8. The sensor structure according to claim 6, wherein the first side surface meets the second side surface at a substantially right angle.

9. The power window control device according to claim 7, wherein the first side surface meets the second side surface at a substantially right angle.

# FIG.1A

# FIG.1B

C(VEHICLE INTERIOR SIDE)

## FIG.2

## FIG.3

# FIG.4

300

WINDOW REGULATOR

310

M

$S_2$ $S_1$

400

1

CONTROLLER

$i_2$

$i_1$

$i_4$

$i_3$

10

100

200

# FIG.5

```
              ┌─────────────┐
              │    START    │
              └─────────────┘
                     │
Step 1               ▼
          ╱─────────────────────╲      No
         ╱   HAS THERE BEEN       ╲───────────┐
         ╲     A TOUCH?           ╱           │
          ╲─────────────────────╱            │
                     │ Yes                    │
Step 2               ▼                        │
          ╱─────────────────────╲   No        │
         ╱      IS Y > 0?         ╲──────────┐│
         ╲                        ╱          ││
          ╲─────────────────────╱           ││
                     │ Yes                   ││
Step 3               ▼              Step 5   ▼│
  ┌─────────────────────────┐   ┌──────────────────────────┐
  │ OUTPUT TRAP SIGNAL S1    │   │ OUTPUT POWER WINDOW DEVICE│
  │                         │   │    ON/OFF SIGNAL S2       │
  └─────────────────────────┘   └──────────────────────────┘
Step 4               │              Step 6   │
  ┌─────────────────────────┐   ┌──────────────────────────┐
  │   WINDOW REGULATOR      │   │ WINDOW REGULATOR OPERATION│
  │    STOP CONTROL         │   │    START/STOP CONTROL     │
  └─────────────────────────┘   └──────────────────────────┘
                     │                       │
                     ◄───────────────────────┘
                     ▼
              ┌─────────────┐
              │     END     │
              └─────────────┘
```

# EP 3 351 714 A1

<div align="center">

**INTERNATIONAL SEARCH REPORT**

</div>

| | International application No. |
|---|---|
| | PCT/JP2016/076091 |

**A. CLASSIFICATION OF SUBJECT MATTER**
*E05F15/46*(2015.01)i, *B60J1/00*(2006.01)i, *B60J1/17*(2006.01)i, *E05F15/689*
(2015.01)i

According to International Patent Classification (IPC) or to both national classification and IPC

**B. FIELDS SEARCHED**

Minimum documentation searched (classification system followed by classification symbols)
E05F15/46, B60J1/00, B60J1/17, E05F15/689

Documentation searched other than minimum documentation to the extent that such documents are included in the fields searched
Jitsuyo Shinan Koho          1922–1996   Jitsuyo Shinan Toroku Koho   1996–2016
Kokai Jitsuyo Shinan Koho    1971–2016   Toroku Jitsuyo Shinan Koho   1994–2016

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | Microfilm of the specification and drawings annexed to the request of Japanese Utility Model Application No. 136255/1983(Laid-open No. 42879/1985)<br>(Kunio KINOSHITA),<br>26 March 1985 (26.03.1985),<br>page 2, line 19 to page 6, line 7<br>(Family: none) | 1,3<br>2,4-9 |

☐ Further documents are listed in the continuation of Box C.     ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 26 October 2016 (26.10.16) | 08 November 2016 (08.11.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 10110574 A